# EUROPÄISCHE PATENTSCHRIFT

(11) **EP 1 384 315 B1**
(45) Veröffentlichungstag und Bekanntmachung des Hinweises auf die Patenterteilung: **11.08.2004**
(21) Anmeldenummer: 02737918.9
(22) Anmeldetag: 04.04.2002
(51) Int. Cl.: H03F 1/00

(54) **VORRICHTUNG ZUM STEUERN EINES RUHESTROMS FÜR EINEN VERSTÄRKERTRANSISTOR UND VERSTÄRKERSCHALTUNG**
DEVICE FOR CONTROLLING A CLOSED CIRCUIT CURRENT FOR AN AMPLIFIER TRANSISTOR AND AMPLIFIER CIRCUIT
DISPOSITIF POUR REGULER UN COURANT DE REPOS DESTINE A UN TRANSISTOR D'AMPLIFICATEUR ET A UN MONTAGE AMPLIFICATEUR

(30) Priorität: 30.04.2001 DE 10121168
(43) Veröffentlichungstag der Anmeldung: 28.01.2004
(73) Patentinhaber: Infineon Technologies AG, 81669 München (DE)
(72) Erfinder: FORSTNER, Johann-Peter, 85643 Steinhoering (DE); SINNESBICHLER, Franz-Xaver, 83101 Rohrdorf / Thansau (DE)
(74) Vertreter: Schoppe, Fritz, Dipl.-Ing.
(86) Internationale Anmeldenummer: PCT/EP2002/003735
(87) Internationale Veröffentlichungsnummer: WO 2002/089314

(56) Entgegenhaltungen:
- EP-A- 0 942 524
- US-A- 5 637 993
- US-A- 5 670 912

## Beschreibung

Die vorliegende Erfindung bezieht sich auf Verstärkerschaltungen und insbesondere auf Verstärkerschaltungen mit einer Vorrichtung zum Steuern eines Ruhestroms eines Verstärkertransistors.

Um den Wirkungsgrad von Leistungsverstärkern zu maximieren, welcher hauptsächlich die Sprechzeit eines Mobiltelefons beeinflußt, da die Batterieleistung begrenzt ist, werden dieselben üblicherweise bei niedrigen Ruheströmen betrieben. Diese Forderung besteht insbesondere bei linearen Leistungsverstärkern, die üblicherweise bei reduzierten Ausgangsleistungspegeln betrieben werden, derart, daß die Verstärkertransistor durch HF-Leistungsspitzen nicht in den nicht-linearen Bereich getrieben werden, was zu Nebenkanalaussendungen führen würde.

Die elektrischen Charakteristika eines Leistungsverstärkers, der in Klasse AB betrieben wird, hängen stark von dem Ruhestrom ab, d. h. dem Transistorstrom, der durch den DC-Arbeitspunkt bestimmt ist, wenn keine Mikrowellenleistung an den Eingang des Verstärkers angelegt wird. Aus diesem Grund muß der Ruhestrom über allen möglichen Betriebsbedingungen konstant bleiben, beispielsweise hinsichtlich der Temperatur und der Versorgungsspannung. Es sei darauf hingewiesen, daß insbesondere bei batteriebetriebenen Mobiltelefonen die Versorgungsspannung Vcc durchaus in Bereichen zwischen 5 V und 3 V variieren kann. Befindet sich das Mobiltelefon in der Ladestation, so wird die maximale Spannung Vcc von 5 V erreicht, während die Spannung deutlich bis auf etwa 3 V abnimmt, wenn die Batterie zur Neige geht.

In jüngster Zeit werden bevorzugt GaAs-basierte Heterobipolartransistoren (HBTs) als Endstufenverstärker in Mobiltelefonen eingesetzt. Solche Verstärkertransistoren haben eine hohe Basis-Emitter-Quellenspannung, die typischerweise bei 1,2 bis 1,3 V liegen kann. Darüber hinaus existiert bei Mobiltelefonen die weitere Anforderung, daß die Versorgungsspannung selten Werte von 5 V übersteigt. Außerdem existiert bei Mobiltelefonen die Möglichkeit, auf eine konstante Referenzspannungsquelle zuzugreifen, die lediglich Spannungswerte im Bereich zwischen 2,7 und 3 V liefert, die jedoch, im Gegensatz zur Versorgungsspannung, nur mit einem begrenzten, relativ kleinen Strom im Bereich unter 10 mA belastet werden kann. Zukünftige Trends gehen dahin, daß, um die Anforderungen an die Referenzspannungsquelle zu verringern, die Referenzspannungsquelle nur noch mit Strömen kleiner 1 mA belastet werden kann.

Unter diesen Voraussetzungen ist es üblicherweise schwierig, eine exakte Ruhestromeinstellung bezüglich der Temperatur zu liefern. Viele der gegenwärtig bekannten Bias-Schaltungen haben hier Probleme, da die verfügbaren Spannungsschwankungen nicht hoch genug sind, um eine konstante Ruhestromeinstellung zu schaffen.

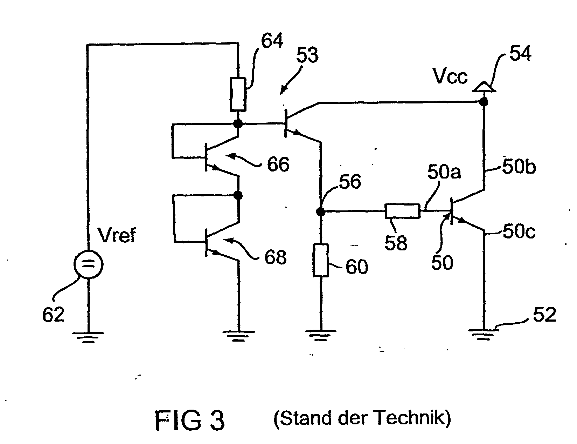

Fig. 3 zeigt eine bekannte Verstärkerschaltung mit Ruhestromtemperaturkompensation. Ausgangsseitig befindet sich ein Verstärkertransistor 50 in Bipolartechnik mit einem Steueranschluß (Basisanschluß) 50a, einem ersten Anschluß (Kollektoranschluß) 50b und einem zweiten Anschluß (Emitteranschluß) 50c. Der Emitteranschluß 50c des Verstärkertransistors 50 ist mit einer Schaltungsmasse 52 verbunden, während der Kollektor mit der Spannungsversorgung Vcc verbunden ist. Die Schaltung umfaßt einen weiteren Bipolartransistor 53, der als Emitterfolger verwendet wird, um geeignete Impedanzverhältnisse am Eingang des Verstärkertransistors 50 zu liefern. Der Emitterfolgertransistor 53 wird ebenfalls von der Versorgungsspannung 54 kollektorseitig versorgt, während sein Emitteranschluß mit einem Knoten 56 verbunden ist, der über einen ersten Widerstand 58 mit dem Steueranschluß 50a des Verstärkertransistors verbunden ist, und der über einen zweiten Widerstand 60 mit der Schaltungsmasse gekoppelt ist.

Eine konstante Referenzspannungsquelle 62 ist zwischen die Schaltungsmasse und einen weiteren Widerstand 64 geschaltet, wobei der andere Anschluß des Widerstands 64 mit dem Steueranschluß des Emitterfolgertransistors 52 verbunden ist. Der zweite Anschluß des Widerstands 64 ist ferner durch zwei als Dioden geschaltete Transistoren 66 und 68 mit der Schaltungsmasse verbunden. Jede Basis-Emitter-Diode der Transistoren 66 und 68 liefert einen Spannungsabfall von etwa 1,2 V, so daß der Steueranschluß des Emitterfolgertransistors auf etwa 2,4 V liegt. An der Basis-Emitter-Diode des Emitterfolgertransistors 52 fällt wiederum eine Spannung von etwa 1,2 V ab, so daß der Knoten 56 auf einem Potential von etwa 1,2 V liegt. Diese Spannung fällt an dem Widerstand 60 ab. Aufgrund der Tatsache, daß das Potential des Steueranschlusses 52 des Emitterfolgertransistors aufgrund der beiden diodenmäßig verwendeten Transistoren 66, 68 immer auf etwa 2,4 V liegt, ist der Strom durch den Widerstand 64 konstant, da die Spannungsquelle 62 eine Konstantspannungsquelle ist. Der Strom durch den ersten Anschluß 50b des Verstärkertransistors 50 und den zweiten Anschluß 50c des Verstärkertransistors 50 zur Schaltungsmasse ist somit ebenfalls konstant, da derselbe bei der in Fig. 5 gezeigten Schaltung dem Strom durch den Widerstand 64 folgt.

Temperaturvariationen des Kollektorstroms durch den Verstärkertransistor 50 treten dann auf, wenn die Basis-Emitter-Spannung der beiden Transistoren 66 und 68 aufgrund von Temperaturschwankungen variiert. Dann variiert das Potential an dem Steueranschluß des Emitterfolgertransistors 52, was dazu führt, daß ein größerer oder kleinerer Strom durch den Widerstand 64 fließt, was wiederum dazu führt, daß sich auch der Kollektorstrom des Verstärkertransistors 50 ändert. Damit die Änderung, des Stroms durch den Widerstand 64 aufgrund der temperaturveränderlichen Basis-Emitter-Spannungen der beiden Transistoren 66 und 68 nicht so stark ins Gewicht fällt, wird ein hoher Spannungsabfall am Widerstand 64 benötigt, da dann eine Basis-Emitter-Spannungsänderung aufgrund der Temperatur der Transistoren 66 und 68 hinsichtlich des Spannungsabfalls am (konstanten) Widerstand 64 nicht oder nicht so stark ins Gewicht fällt. Ist jedoch der Spannungsabfall an dem Widerstand 64 aufgrund vorgegebener kleiner Referenzspannungen klein, so wirken sich Änderungen der Basis-Emitter-Spannungen der Transistoren 66 und 68 wesentlich stärker auf den Strom durch den Widerstand 64 und damit auf den Kollektorstrom des Verstärkertransistors 50 aus.

Um die Schaltung, die in Fig. 5 gezeigt ist, betreiben zu können, wird somit eine Referenzspannungsquelle benötigt, die mehr als 2,4 V liefert, damit die Schaltung überhaupt zu arbeiten beginnt. Eine sinnvolle Temperaturkompensation wird jedoch erst bei Spannungswerten für die Referenzspannungsquelle von oberhalb 4 V erreicht, da dann der Spannungsabfall am Widerstand 64 größer ist als der Spannungsabfall an den Transistoren 66 und 68, welche temperaturvariabel sind, während der Widerstand 64 als über der Temperatur konstant angenommen werden kann.

Ein weiterer Nachteil der in Fig. 5 gezeigten Schaltung ist, daß lediglich eine Vorwärtssteuerung dahingehend vorgenommen wird, daß Temperaturvariationen in einem gewissen Bereich "verschleiert", jedoch nicht ausgeregelt werden.

Ein weiterer Nachteil der in Fig. 5 gezeigten Schaltung besteht darin, daß spezielle DC-Bias-Impedanzen für eine Verstärkersttufe bereitgestellt werden müssen, um unterschiedliche Betriebsbedingungen (linearer Modus, gesättigter Modus und linearer Modus bei niedrigen Ausgangsleistungspegeln) zu erreichen.

Die WO 01/22573 offenbart eine Schaltungsanordnung zur Regelung des Arbeitspunkts eines Leistungsverstärkers mit einem Stromspiegel, wobei ein Spiegeltransistor den Leistungstransistor bildet, während der andere Spiegeltransistor an seiner Basis mit einem zweistufigen Verstärker verbunden ist. Der zweistufige Verstärker umfasst zwei kaskadiert Transistoren in Emitterschaltung, wobei beide Emitter auf Masse gelegt sind. Das Ausgangssignal des zweistufigen Verstärkers wird über einen Transistor in Kollektorschaltung an die Basis des anderen Spielgeltransistors gelegt, um den Kollektorstrom durch diesen Spielgeltransistors rückkopplungsmäßig zu regeln.

Nachteilig an dieser Schaltungsanordnung ist die Tatsache, dass die Schaltung aufgrund der zwei kaskadierten Verstärkertransistoren eine Schwingneigung bei niedrigen Frequenzen besitzt, die lediglich durch einen Kondensator mit einem sehr hohen Kapazitätswert im nF-Bereich unterdrückt werden kann.

Weiterhin erfordert diese Schaltung unbedingt, dass die Versorgungsspannung der kaskadierten Verstärkertransistoren eine Konstantspannungsquelle ist, so dass eine Konstantspannungsquelle mit relativ hohem Stromoutput benötigt wird bzw. nicht die Flexibilität besteht, auf eine Konstantspannungsquelle zu verzichten und im Falle einer Telephonanwendung allein die Batteriespannung Vcc zu nehmen. Dies ist darauf zurückzuführen, dass die beiden kaskadierten Verstärkertransistoren emitterseitig auf Masse gelegt sind.

Die Aufgabe der vorliegenden Erfindung besteht darin, eine verbesserte Vorrichtung zum Steuern eines Ruhestroms für einen Verstärkertransistor sowie eine Verstärkerschaltung zu schaffen.

Diese Aufgabe wird durch eine Vorrichtung gemäß Patentanspruch 1 oder durch eine Vorrichtung gemäß Patentanspruch 13 gelöst.

Der vorliegenden Erfindung liegt die Erkenntnis zugrunde, daß eine aktive Steuerschleife eingesetzt werden kann, um eine konstante Ruhestromeinstellung über einem breiten Temperaturbereich oder hinsichtlich von Parameterschwankungen der Transistoren zu schaffen. Erfindungsgemäß wird nicht der Kollektorstrom des Verstärkertransistors selbst unmittelbar rückkopplungsmäßig gesteuert, da der Zugang schaltungstechnisch aufwendig ist, zumal in diesem Bereich üblicherweise der HF-Eingang ist, da die zu verstärkenden HF-Signale an den Steueranschluß des Verstärkertransistors anzulegen sind.

Erfindungsgemäß wird ein Spiegeltransistor so mit dem Verstärkertransistor gekoppelt, daß ein Stromspiegel gebildet ist, so daß der Kollektorstrom in den Spiegeltransistor identisch zu dem Kollektorstrom in den Verstärkertransistor ist bzw., wenn die Transistoren nicht die gleiche Größe haben, mit der Transistorfläche skaliert ist, d. h. zu dem Kollektorstrom durch den Spiegeltransistor proportional ist. Zur rückkopplungsmäßigen Steuerung des Kollektorstroms, derart, daß derselbe von Temperaturvariationen bzw. Bauelementeparametern unabhängig ist, ist eine Erfassungseinrichtung vorgesehen, um die Spannung an dem Kollektoranschluß des Spiegeltransistors zu erfassen, und um ein Ausgangssignal als Reaktion auf die Spannung an dem Kollektoranschluß des Spiegeltransistors zu liefern.

Die Erfassungseinrichtung ist Transistor ausgeführt, dessen Steueranschluß (Basis) auf einem hohen Potential liegt, und dessen beide anderen Anschlüsse (Basis und Kollektor) ebenfalls nicht auf Masse gelegt sind. Die Basis ist direkt oder über eine Konstantspannungsquelle (im Falle von VCC als Versorgungsspannung oder im Falle einer Konstantspannungsquelle als Versorgungsspannung) mit der Spannung verbunden. Damit besitzt die Schaltung die Option, dass die Basis floaten kann und damit Spannungsschwankungen der Versorgungsspannung folgen kann, so dass optional auch auf die Konstantspannungsquelle verzichtet werden kann.

Das Ausgangssignal der Erfassungseinrichtung wird einer Rückkopplungseinrichtung zugeführt, um das Ausgangssignal der Erfassungseinrichtung zu empfangen und um ein Rückkopplungssignal zu dem Steueranschluß des Spiegel transistors zu liefern, damit der Spiegeltransistor so gesteuert wird, daß der Kollektorstrom temperaturunabhängig ist.

Die Vorrichtung zum Steuern des Ruhestroms gemäß der vorliegenden Erfindung umfaßt ferner eine resistive Einrichtung mit zwei Anschlüssen, wobei der erste Anschluß der resistiven Einrichtung mit einer Spannung verbindbar ist, und wobei der zweite Anschluß der resistiven Einrichtung mit dem Kollektoranschluß des Spiegeltransistors verbunden ist.

Gemäß einem ersten Ausführungsbeispiel der vorliegenden Erfindung ist die Spannung an der resistiven Einrichtung eine konstante Referenzspannung. Alternativ kann jedoch gemäß einem anderen Ausführungsbeispiel der vorliegenden Erfindung auch die stark schwankende Versorgungsspannung verwendet werden, da, im Gegensatz zum Stand der Technik, Versorgungsspannungsschwankungeh aufgrund der Rückkopplungsschleife ausgeregelt werden und die Erfassungseinrichtung diesen Schwankungen folgen kann.

Gemäß der vorliegenden Erfindung wird, unabhängig davon, ob eine Konstantspannungsquelle oder eine Versorgungsspannungsquelle an die resistive Einrichtung angelegt wird, für die Erfassungseinrichtung ein Transistor verwendet werden, dessen Steueranschluß (Basis) mit der Spannung elektrisch verbunden ist.

Bei dem bevorzugten Ausführungsbeispiel der vorliegenden Erfindung ist die Rückkopplungseinrichtung als Emitterfolgertransistor ausgeführt, dessen Emitter mit dem Steueranschluß des Spiegeltransistors elektrisch verbunden ist, während sein Steueranschluß mit der Spannungserfassungseinrichtung gekoppelt ist.

Die erfindungsgemäße Schaltung ist dahingehend vorteilhaft, daß Kollektorstromschwankungen aufgrund der rückkopplungsmäßigen Natur der Schaltung ausgeregelt werden, so daß bei bevorzugten Ausführungsbeispielen der vorliegenden Erfindung auf eine Konstantspannungsquelle sogar verzichtet werden kann und die resistive Einrichtung statt dessen mit der stark schwankenden Versorgungsspannung verbunden wird, solange die Schwankungen der Versorgungsspannung auch der Erfassungseinrichtung zugeführt werden.

Ein weiterer Vorteil der erfindungsgemäßen Vorrichtung besteht darin, daß kleinere Spannungspegel für die Konstantspannungsquelle oder die Versorgungsspannungsquelle Vcc ausreichend sind. Insbesondere mußte die Versorgungsspannung oder Konstantspannungsquelle im Stand der Technik deutlich größer als das Doppelte der-Basis-Emitter-Spannung eines Bipolartransistors sein. Erfindungsgemäß muß die Versorgungsspannung oder Konstantspannung gemäß der vorliegenden Erfindung lediglich größer als zwei Basis-Emitter-Spannungsabfall-Einheiten sein, wobei prinzipiell auch Werte knapp oberhalb dieses Grenzwerts ausreichen, da Basis-Emitter-Spannungsschwankungen aufgrund von veränderlichen Temperaturen ohnehin rückkopplungsmäßig ausgeregelt werden.

Bevorzugte Ausführungsbeispiele der vorliegenden Erfindung werden nachfolgend bezugnehmend auf die beiliegenden Zeichnungen näher erläutert. Es zeigen:
- Fig. 1: eine Verstärkerschaltung mit einer Vorrichtung zum Steuern eines Ruhestroms mit einem Transistor als Erfassungseinrichtung und einer Konstantspannungsquelle;
- Fig. 2: eine Verstärkerschaltung mit einer Vorrichtung zum Steuern eines Ruhestroms mit einem Transistor als Erfassungseinrichtung und lediglich einer Versorgungsspannungsquelle Vcc; und
- Fig. 3: eine bekannte Verstärkerschaltung mit einer bekannten Vorrichtung zum Steuern eines Ruhestroms.

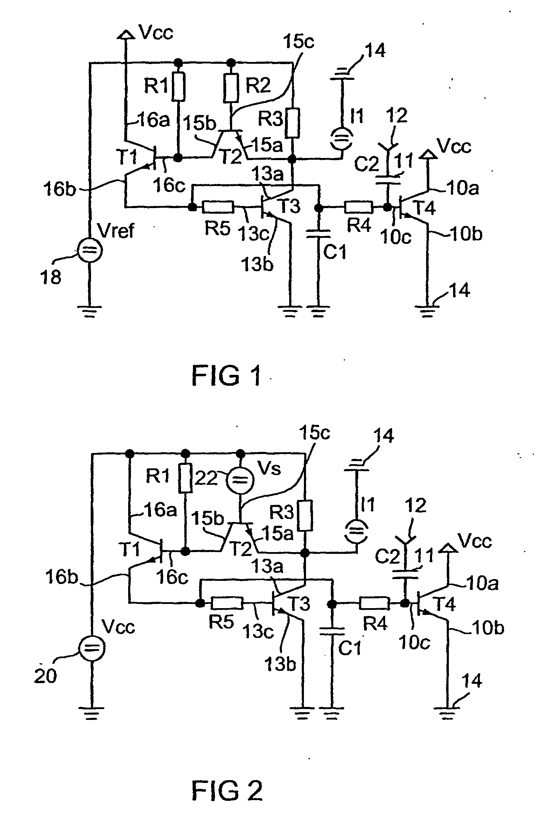

Fig. 1 zeigt eine erfindungsgemäße Verstärkerschaltung mit einer Vorrichtung zum Steuern eines Ruhestroms für einen Verstärkertransistor T4. Der Verstärkertransistor T4 umfaßt einen ersten Anschluß 10a, einen zweiten Anschluß 10b sowie einen Steueranschluß 10c. Bei bevorzugten Ausführungsbeispielen der vorliegenden Erfindung sind die Transistoren als Bipolartransistoren und insbesondere als Heterobipolartransistoren auf GaAs (HBTs) ausgeführt. In diesem Fall ist der Steueranschluß 10c der Basisanschluß, während der erste Anschluß 10a der Kollektoranschluß und der zweite Anschluß 10b der Emitteranschluß des Verstärkertransistors T4 ist. Der Verstärkertransistor T4 bildet beispielsweise eine Verstärkerstufe oder die Endstufe einer Kette von kaskadierten Verstärkern. Alternativ könnte er auch die Eingangsstufe einer solchen Kette sein. Wie es in Fig. 1 schematisch dargestellt ist, kann der Basisanschluß 10c über einen Serienkondensator 11 mit einer Quelle 12 verbunden sein, um das zu verstärkende Nutzsignal dem Verstärkertransistor T4 zuzuführen, damit es verstärkt wird.

Der Verstärkertransistor T4 ist mit einem Spiegeltransistor T3 so verbindbar, daß sich ein Stromspiegel zwischen dem Spiegeltransistors T3 und dem Verstärkertransistor T4 bildet. Insbesondere ist der Steueranschluß 10c des Verstärkertransistors T4 mit einem Steueranschluß 13c des Spiegeltransistors T3 über ein Impedanznetzwerk verbunden, das eine T-Schaltung mit zwei Widerständen R4 und R5 in den Längszweigen und einen Kondensator C1 im Querzweig umfaßt, gekoppelt. Der Spiegeltransistor T3 umfaßt ferner einen ersten Anschluß 13a und einen zweiten Anschluß 13b. Wenn der Spiegeltransistor ebenfalls als Bipolartransistor ausgeführt ist, ist der erste Anschluß 13a desselben der Kollektoranschluß, während der zweite Anschluß 13b desselben der Emitteranschluß ist. Wie es in Fig. 1 gezeigt ist, sind die Emitteranschlüsse der beiden Transistoren T3 und T4 mit einer Schaltungsmasse 14 verbunden. Es sei darauf hingewiesen, daß es wesentlich ist, daß der Spiegeltransistor T3 und der Verstärkertransistor T4 eine Stromspiegelschaltung bilden. Hierzu müßte das Widerstandsnetzwerk bestehend aus R5, R4 und C1 nicht unbedingt vorhanden sein. Es würde lediglich ausreichen, daß die beiden Steueranschlüsse miteinander verbunden sind, derart, daß der Kollektorstrom durch den Transistor T3 identisch zum Kollektorstrom durch den Transistor T4 ist bzw. entsprechend der Transistorgröße skaliert ist. Generell gilt bei Stromspiegeln, daß der Kollektorstrom durch den Verstärkertransistor proportional zum Kollektorstrom durch den Spiegeltransistor ist, wobei diese Proportionalität entweder in einer Gleichheit besteht, wenn beide Transistoren gleich dimensioniert sind, oder in einer linearen Abhängigkeit mit einem Faktor gemäß den geometrischen Flächen der Transistoren.

Der erste Anschluß 13a des Spiegeltransistors T3 ist über einen Widerstand R3, der die resistive Einrichtung bildet, mit einer Spannungsquelle verbunden, die bei dem in Fig. 1 gezeigten Ausführungsbeispiel eine Konstantreferenzspannungsquelle 18 ist. Im Falle einer bipolaren Ausführung beträgt das Potential an dem Kollektoranschluß des Spiegeltransistors T3 aufgrund des Basis-Emitter-Spannungsabfalls des Transistors T2 etwa 1,6 V im Gegensatz zu etwa 2,4 V bei der in Fig. 3 gezeigten bekannten Schaltung, so daß kleinere Referenzspannungswerte ausreichen.

Es sei darauf hingewiesen, dass die oben angegebenen Werte für GaAs-HBTs gelten. Ein Basis-Emitter-Spannungsabfall für SiGe-Transistoren liegt bei etwa 0,6 V. Für InP-Transistoren beträgt dieser Wert 0,7 V.

Die Erfassungseinrichtung zum Erfassen der Spannung an dem ersten Anschluß 13a des Spiegeltransistors, d. h. des Kollektoranschlusses des Spiegel transistors, wenn derselbe als Bipolartransistor ausgeführt ist, umfaßt einen weiteren Transistor T2 mit einem ersten Anschluß 15a, einem zweiten Anschluß 15b und einem Steueranschluß 15c, wobei der Steueranschluß 15c über einen Widerstand R2 mit der Konstantreferenzspannungsquelle 14 verbunden ist. Der Strom durch den Widerstand R2, d. h. der Basisstrom des Transistors T2 ist klein, so daß der Spannungsabfall am Widerstand R2 vernachlässigbar klein ist. Parallel zu dem Transistor T2 und dem Widerstand R2 ist ein Widerstand R1 geschaltet.

Mit dem Kollektoranschluß des Transistors T2 ist ein Steueranschluß 16c des Transistors T1 gekoppelt, wobei ein erster Anschluß 16a des Transistors T1 mit einer Spannungsversorgung Vcc verbunden ist, während der zweite Anschluß 16b des Transistors T1, der als Emitterfolger fungiert, mit dem Steueranschluß des Spiegeltransistors 13c entweder direkt oder, wie es in Fig. 1 gezeigt ist, optional über den Widerstand R5 verbunden ist. Der Emitterfolgertransistor T1 bildet eine Rückkopplungseinrichtung zum Empfangen des Ausgangssignals der Erfassungseinrichtung, d. h. der Kollektorspannung des Transistors T2, und zum Liefern eines Rückkopplungssignals, d. h. der Emitterspannung des Transistors T1, zu dem Spiegeltransistor, um die Rückkopplungsschleife zu schließen.

Bei der in Fig. 1 gezeigten Schaltung bilden somit die beiden Transistoren T3 und T4 eine Stromspiegelkonstellation. Der Transistor T2 wird zum Erfassen der Kollektorspannung von T3 verwendet. Der Transistor T1 wirkt als Emitterfolger. Die Rückkopplungsschleife um den Spiegeltransistor T3 wird durch Verbindendes Kollektors T3 mit dem Emitter von T2 geschlossen, dessen Kollektor wiederum mit der Basis von T1 verbunden ist, dessen Emitter schließlich wieder mit der Basis von T3 verbunden ist.

Die Aufgabe der Schaltung besteht darin, einen konstanten Kollektorstrom in den Verstärkertransistor T4 zu bringen, der Teil einer HF-Verstärkerkette sein kann. Dies wird erreicht, indem ein konstanter Strom in den Spiegeltransistor T3 injiziert wird, derart, daß auch ein konstanter Strom in den Kollektor 10a des Transistors T4 gebracht wird, da diese beiden Transistoren einen Stromspiegel bilden. Der Kollektorstrom von dem Transistor T3 ist konstant, wenn der Spannungsabfall über der resistiven Einrichtung R3 konstant ist, da der Emitterstrom in den Transistor T2 wesentlich kleiner als der Kollektorstrom des Transistors T3 ist.

Nachfolgend wird, um das Prinzip der in Fig. 1 gezeigten Schaltung zu erklären, angenommen, daß die Referenzspannungsquelle 18 2,8 V liefert. Ferner wird angenommen, daß ein durch eine optionale Stromquelle I1 initiierbarer Strom gleich Null ist. Weiterhin sei darauf hingewiesen, daß kein wesentlicher Spannungsabfall über dem Widerstand R2 auftritt, so daß die Basisspannung von T2 gleich Vref ist. Die Basisspannung an dem Transistor T2 führt dazu, daß die Emitterspannung von T2 und die Kollektorspannung von T3 um einen Basis-Emitter-Spannungsabfall (Vbe = 1,2 bis 1,3 V für GaAs) kleiner als Vref ist, wie es bereits ausgeführt worden ist. Dies bedeutet, daß der Spannungsabfall über R3 konstant ist, wodurch ein konstanter Kollektorstrom in T3 injiziert wird. Der Transistor T2 zieht je nach Bedarf so viel Kollektorstrom, daß seine Kollektorspannung etwa das Doppelte von Vbe beträgt. In anderen Worten bedeutet dies, daß die Kollektorspannung des Transistors T2 gleich der Summe aus der Basis-Emitter-Spannung Vbe des Transistors T3 und der Basis-Emitter-Spannung Vbe des Transistors T1 ist.

Im nachfolgenden wird auf die Funktion der rückgekoppelten Steuerschleife eingegangen, wenn die Stromsituation aus dem Gleichgewicht gerät. Hierzu sei beispielhaft angenommen, daß der Transistor T3, d. h. der Spiegeltransistor, die Tendenz hat, mehr Kollektorstrom zu ziehen, beispielsweise aufgrund von Temperaturvariationen, Teile-zu-Teile-Variationen etc. Da der Spiegeltransistor T3 in Stromspiegelanordnung mit dem Verstärkertransistor T4 gekoppelt ist, führt ein steigender Kollektorstrom des Transistors T3 unmittelbar dazu, daß auch der Kollektorstrom des Transistors T4 ansteigt. Dies ist nicht wünschenswert, da dann die elektrischen Parameter des Verstärkertransistors verändert sind. Wesentlich ist, daß der Transistor T4, d. h. der Verstärkertransistor, immer einen konstanten Betriebsruhestrom hat, d. h. bei keiner angelegten HF-Leistung immer im gleichen Arbeitspunkt betrieben wird.

Die Erfassungseinrichtung zum Erfassen der Spannung an dem ersten Anschluß des Spiegeltransistors, d. h. bei dem in Fig. 1 gezeigten Ausführungsbeispiel der Transistor T2, erfaßt die veränderte Kollektorspannung an dem Kollektor des Spiegeltransistors, die im Fall eines größeren Kollektorstroms abfällt. Dies führt unmittelbar dazu, daß auch die Emitterspannung des Transistors T2 abfällt, da der Emitter des Transistors T2, d. h. der Anschluß 15a des Transistors T2, auf dem selben Potential wie der Kollektor 13a des Spiegeltransistors T3 liegt. Da die Basisspannung von T2 konstant ist, steigt der Basisstrom in dem Transistor T2 an, was unmittelbar dazu führt, daß auch der Kollektorstrom durch den Anschluß 15b des Transistors T2 ansteigt, da folgender Zusammenhang gilt: Ic(T2) = β Ib(T2). Dieser erhöhte Strom Ic(T2) bewirkt eine Zunahme des Spannungsabfalls über den zum Transistor T2 parallel geschalteten Widerstand R1, da der höhere Kollektorstrom von der Referenzspannungsquelle über den Widerstand R1 gezogen wird. Das Resultat davon ist, daß die Kollektorspannung von T2 abfällt, derart, daß auch die Basisspannung des Emitterfolgertransistors T1, der als Rückkopplungseinrichtung fungiert, abfällt. Die Emitterspannung des Transistors T1 folgt der Basisspannung, derart, daß auch die Basisspannung des Spiegeltransistors T3, d. h. die Spannung an dem Steueranschluß des Spiegeltransistors, abfällt. Die Basisspannung an dem Spiegeltransistor T3 wird reduziert, bis der Kollektorstrom Ic(T3) wieder zurück auf seinem Anfangswert ist, derart, daß die gewünschte Situation für den Kollektorstrom des Verstärkertransistors wieder hergestellt ist. Wenn der Spiegeltransistor T3 dagegen die Tendenz hat, weniger Strom zu ziehen, ist das Verhalten der gesamten Schaltung genau umgekehrt.

Bei einem bevorzugten Ausführungsbeispiel der vorliegenden Erfindung ist zwischen dem ersten Anschluß des Spiegeltransistors (13a) und der Schaltungsmasse 14 eine Konstantstromquelle I1 geschaltet. Diese Konstantstromquelle I1 kann verwendet werden, um den Kollektorstrom des Spiegeltransistors T3 und damit den Kollektorstrom des Verstärkertransistors T4 gesteuert zu variieren. Wenn der Strom an dem Kollektor von T3 der Masse zugeführt wird, wird der Strom, der in den Kollektor von T3 injiziert wird, reduziert.

Eine äquivalente Stromkontrolle kann auch durchgeführt werden, indem die Basisspannung von T2 variiert wird. Wenn die Spannung an der Basis des Transistors T2, also an dem Steueranschluß 15c, reduziert wird, folgt auch die Spannung an dem Kollektor des Transistors T3, so daß der Spannungsabfall über R3 erhöht wird, was wiederum dazu führt, daß der Kollektorstrom des Transistors T3 ansteigt.

Im nachfolgenden wird auf Fig. 2 Bezug genommen, um ein weiteres bevorzugtes Ausführungsbeispiel der vorliegenden Erfindung darzustellen, das ohne eine Konstantreferenzspannungsquelle auskommt. Anstelle der Konstantreferenzspannungsquelle 14 von Fig. 1 wird die Versorgungsspannungsquelle Vcc verwendet, die, wie es ausgeführt worden ist, einerseits größere Spannungswerte liefert, andererseits jedoch sehr stark schwankt. Wesentlich ist, daß die Basis des Transistors T2, der die Erfassungseinrichtung darstellt, ebenfalls mit der Versorgungsspannungsquelle Vcc verbunden ist, derart, daß das Potential an der Basis des Transistors. T2 genauso stark schwankt wie die Versorgungsspannungsquelle Vcc 20. Für den Fall, daß der Transistor T2 als Bipolartransistor ausgeführt wird, würde eine Spannung von 5 V an der Basis des Transistors T2 zu hoch sein und zu einer Vorwärtspolung des Basis-Kollektor-Übergangs dieses Transistors führen. Im Falle einer relativ hohen Spannungsquelle Vcc 20 wird es daher bevorzugt, die Spannung an der Basis des Transistors Vcc zu verringern, wie es durch eine Konstantspannungsquelle Vs 22 dargestellt ist, die hinsichtlich ihrer Polarität der Versorgungsspannungsquelle Vcc entgegengesetzt geschaltet ist. Wesentlich ist jedoch, daß die Spannungsquelle Vs eine Konstantspannungsquelle ist, derart, daß die Schwankungen der Versorgungsspannungsquelle 20 nach wie vor an der Basis des Transistors T2 anliegen. In diesem Fall folgt die Spannung an der Basis des Transistors T2, d. h. Vb(T2), der Differenz aus Vcc - Vs, derart, daß der Spannungsabfall über R3 wieder konstant ist, was wiederum dazu führt, daß ein konstanter Strom in den Spiegeltransistor T3 und damit auch in den Verstärkertransistor T4 injiziert wird.

Es sei darauf hingewiesen, daß es bevorzugt wird, den Verstärkertransistor T4 zusammen mit der restlichen Schaltung monolithisch zu integrieren, da Stromspiegelanordnungen um so besser funktionieren, je gleicher die Charakteristika des Spiegeltransistors und des Verstärkertransistors sind. Alternativ wird eine monolithische Integration sämtlicher Schaltungen ohne den Verstärkertransistor bevorzugt, wenn der Verstärkertransistor beispielsweise Teil eines anderen Chips ist und die Stromsteuerschaltung gewissermaßen nachgerüstet werden muß.

Zur Dämpfung einer Schwingungsneigung der Rückkopplungsschleife ist der Kondensator C1 zwischen der Masse 14 und dem Ausgang 16b der Rückkopplungseinrichtung, d. h. dem Emitteranschluß des Transistors T1, vorgesehen. Alternativ oder zusätzlich ist ein Kondensator C1' zwischen den Eingang 16c der Rückkopplungseinrichtung T1 und die Schaltungsmasse 14 geschaltet ist. Bei der erfindungsgemäßen Schaltung genügen kleine Kapazitätswerte, die im Bereich von 1 und 10 pF liegen können.

Die erfindungsgemäße Vorrichtung ermöglicht somit die Verwendung von Referenzspannungsquellen mit geringen Spannungswerten oder sogar den Verzicht auf eine Konstantspannungsquelle, wenn statt der Konstantspannungsquelle eine schwankende Schaltungsversorgungsspannungsquelle eingesetzt wird. Kollektorströme durch den Spiegeltransistor werden durch die Rückkopplungsschleife automatisch auf einen konstanten Ruhestromwert geregelt, welcher den Arbeitspunkt des Verstärkertransistors (T4) festlegt.

Bezugszeichenliste
- 10a: erster Anschluß des Verstärkertransistors
- 10b: zweiter Anschluß des Verstärkertransistors
- 10c: Steueranschluß des Verstärkertransistors
- 11: Koppelkondensator
- 12: Quelle
- 13a: erster Anschluß des Spiegeltransistors
- 13b: zweiter Anschluß des Spiegeltransistors
- 13c: Steueranschluß des Spiegeltransistors
- 14: Schaltungsmasse
- 15a: erster Anschluß des Erfassungstransistors
- 15b: zweiter Anschluß des Erfassungstransistors
- 15c: Steueranschluß des Erfässungstransistors
- 16a: erster Anschluß des Rückkopplungstransistors
- 16b: zweiter Anschluß des Rückkopplungstransistors
- 16c: Steueranschluß des Rückkopplungstransistors
- 18: Referenzspannungsquelle
- 20: Schaltungsversorgungsspannungsquelle Vcc
- 22: Konstantspannungsquelle
- 30: Basisspannungsquelle für den ersten Differenzverstärkertransistor
- 50: Verstärkertransistor
- 50a: Basisanschluß des Verstärkertransistors
- 50b: Kollektoranschluß des Verstärkertransistors
- 50c: Emitteranschluß des Verstärkertransistors
- 52: Schaltungsmasse
- 53: Emitterfolgertransistor
- 54: Schaltungsversorgungsspannung Vcc
- 56: Knoten
- 58: Widerstand
- 60: Widerstand
- 62: Referenzspannungsquelle
- 64: Widerstand
- 66: erste Basis-Emitter-Diode
- 68: zweite Basis-Emitter-Diode

## Patentansprüche

1. Vorrichtung zum Steuern eines Ruhestroms für einen Verstärkertransistor (T4), wobei der Verstärkertransistor (T4) einen Steueranschluß (10c) und einen ersten (10a) und einen zweiten (10b) Anschluß aufweist, die angeordnet sind, damit der Ruhestrom über den ersten und den zweiten Anschluß (10a, 10b) durch den Verstärkertransistor (T4) fließen kann, mit folgenden Merkmalen:
einem Spiegeltransistor (T3) mit einem Steueranschluß (13c), einem ersten Anschluß (13a) und einem zweiten Anschluß (13b), der so mit dem Verstärkertransistor (T4) verbindbar ist, daß der Spiegeltransistor (T3) mit dem Verstärkertransistor (T4) einen Stromspiegel bildet, so daß der Ruhestrom des Verstärkertransistors (T4) gleich oder proportional zu dem Strom durch den ersten und zweiten Anschluß (13a, 13b) des Spiegeltransistors (13) ist;
einer Erfassungseinrichtung (T2, R1) zum Erfassen der Spannung an dem ersten Anschluß (13a) des Spiegeltransistors (T3) und zum Liefern eines Ausgangssignals als Reaktion auf die Spannung an dem ersten Anschluß (13a) des Spiegeltransistors (13), wobei die Erfassungseinrichtung einen Erfassungstransistor (T2) mit einem Steueranschluß (15c) und einem ersten und einem zweiten Anschluß (15a, 15b) aufweist, wobei der Steueranschluß (15c) mit einer Spannungsquelle (18, 20) elektrisch verbindbar ist, und wobei der erste Anschluß (15a) mit dem ersten Anschluß (13a) des Spiegeltransistors verbunden ist, und wobei an dem zweiten Anschluß (15b) das Ausgangssignal der Erfassungseinrichtung ausgebbar ist;
einer Rückkopplungseinrichtung (T1) zum Empfangen des Ausgangssignals der Erfassungseinrichtung (T2, R1) und zum Liefern eines Rückkopplungssignals, das von dem Ausgangssignal der Erfassungseinrichtung abhängt, zu dem Steueranschluß (13c) des Spiegel transistors (T3); und
einer resistiven Einrichtung (R3) mit zwei Anschlüssen, wobei der erste Anschluß der resistiven Einrichtung (R3) mit einer Spannung (18, 20) verbindbar ist, und wobei der zweite Anschluß der resistiven Einrichtung (R3) mit dem ersten Anschluß (13a) des Spiegeltransistors verbunden ist, so daß ein Strom durch die resistive Einrichtung (R3) aufgrund der Spannung (18, 20) durch ein Signal an dem Steueranschluß (13c) des Spiegeltransistors (13) steuerbar ist.

2. Vorrichtung gemäß Anspruch 1,
bei der die Rückkopplungseinrichtung einen Rückkopplungstransistor (T1) mit einem Steueranschluß (16c) und einem ersten und einem zweiten Anschluß (16a, 16b) aufweist, wobei an den Steueranschluß (16c) das Ausgangssignal der Erfassungseinrichtung (T2, R1) angeschlossen ist, wobei der erste Anschluß (16a) mit einer Versorgungsspannung (Vcc) für die Vorrichtung verbindbar ist, wobei an den zweiten Anschluß (16b) das Rückkopplungssignal ausgebbar ist, und wobei der zweite Anschluß (16b) mit dem Steueranschluß (13c) des Spiegeltransistors (T3) verbunden ist.

3. Vorrichtung gemäß Anspruch 2, bei der die Rückkopplungseinrichtung einen Emitterfolger bzw. einen Source-Folger aufweist.

4. Vorrichtung gemäß einem der vorhergehenden Ansprüche,
bei der die Erfassungseinrichtung ferner eine resistive Einrichtung (R1) aufweist, die zwischen der Spannungsquelle (18, 20) und dem zweiten Anschluß (15b) des Erfassungstransistors (T2) geschaltet ist.

5. Vorrichtung gemäß einem der vorhergehenden Ansprüche, bei der die Spannung, mit der der erste Anschluß der resistiven Einrichtung (R3) verbindbar ist, eine konstante Referenzspannung (18) ist, wobei die Erfassungseinrichtung mit der konstanten Referenzspannung versorgbar ist, und wobei der Verstärkertransistor (T4) und die Rückkopplungseinrichtung (T1) mit einer Schaltungsversorgungsspannung (Vcc) versorgbar sind.

6. Vorrichtung gemäß einem der vorhergehenden Ansprüche,
bei der die Spannung, mit der der erste Anschluß der resistiven Einrichtung (R3) verbindbar ist, eine Schaltungsversorgungsspannung (Vcc) ist, mit der die Rückkopplungseinrichtung (T1) und der Verstärkertransistor (T4) versorgbar sind; und
bei der die Erfassungseinrichtung (T2) mit einer Spannung (22) versorgbar ist, deren Variation über der Zeit der Variation über der Zeit der Versorgungsspannung (Vcc) (20) entspricht.

7. Vorrichtung gemäß einem der vorhergehenden Ansprüche, die ferner folgendes Merkmal aufweist:
eine Einrichtung (11) zum Einprägen eines zusätzlichen Stroms in den ersten Anschluß (13a) des Spiegeltransistors (T3).

8. Vorrichtung gemäß einem der vorhergehenden Ansprüche,
bei der der Steueranschluß (13c) des Spiegeltransistors (T3) mit dem Steueranschluß (10c) des Verstärkertransistors (T4) über ein Impedanznetzwerk (R4, R5, C1) verbindbar ist,
bei der der zweite Anschluß (13b) des Spiegeltransistors mit einer Schaltungsmasse (14) verbindbar ist, und
bei der der zweite Anschluß (10b) des Verstärkertransistors (T4) mit der Masse (14) verbindbar ist.

9. Vorrichtung nach einem der vorhergehenden Ansprüche, die ferner eine Dämpfungseinrichtung (C1; C1') zum Dämpfen einer Schwingneigung der Vorrichtung aufweist.

10. Vorrichtung nach Anspruch 9, bei der die Dämpfungseinrichtung ein Kondensator (C1) ist, der zwischen die Basis des Spiegeltransistors (T3) und eine Schaltungsmasse (14) geschaltet ist.

11. Vorrichtung nach Anspruch 9, bei der die Dämpfungseinrichtung ein Kondensator (C1') ist, der zwischen den Eingang (16c) der Rückkopplungseinrichtung (T1) und eine Schaltungsmasse (14) geschaltet ist.

12. Vorrichtung nach Anspruch 10 oder 11, bei der der Kondensator einen Kapazitätswert zwischen 1 und 10 pF aufweist.

13. Verstärkerschaltung mit folgenden Merkmalen:
einem Verstärkertransistor (T4) mit einem Steueranschluß (10c) und einem ersten und einem zweiten Anschluß (10a, 10b), die angeordnet sind, damit ein Ruhestrom über den ersten und den zweiten Anschluß (10a, 10b) durch den Verstärkertransistor (T4) fließen kann;
einer Vorrichtung zum Steuern des Ruhestroms des Verstärkertransistors (T4) gemäß einem der Ansprüche 1 bis 12,
wobei der erste Anschluß (10c) des Verstärkertransistors mit einer Versorgungsspannung (Vcc) verbindbar ist;
wobei der zweite Anschluß (10b) des Verstärkertransistors mit einer Schaltungsmasse (14) verbindbar ist;
wobei der Steueranschluß (13c) des Spiegel transistors (T3) mit dem Steueranschluß (10c) des Verstärkertransistors (T4) verbunden ist; und
wobei ein Nutzsignal (RF IN) an den Steueranschluß (10c) des Verstärkertransistors (T4) anlegbar ist, so daß an dem ersten Anschluß (10a) des Verstärkertransistors ein verstärktes Nutzsignal ausgebbar ist.

14. Verstärkerschaltung gemäß Anspruch 13, bei der der Verstärkertransistor (T4) und der Spiegeltransistor (T3) Bipolartransistoren sind.

15. Verstärkerschaltung gemäß Anspruch 14, bei der der Verstärkertransistor (T4) und der Spiegeltransistors (T3) Heterobipolartransistoren sind.

16. Verstärkerschaltung gemäß einem der Ansprüche 13 bis 15, bei der der Verstärkertransistor (T4) und der Spiegeltransistor (T3) als eine monolithisch integrierte Mikrowellenschaltung ausgeführt sind.

17. Verstärkerschaltung gemäß einem der Ansprüche 13 bis 16, die vollständig als monolithisch integrierte Mikrowellenschaltung ausgeführt ist.

18. Verstärkerschaltung nach einem der Ansprüche 13 bis 17, bei der der Steueranschluß (13c) des Spiegel transistors (T3) über ein Impedanznetzwerk (R4, R5, C1) mit dem Steueranschluß (10c) des Verstärkertransistors (T4) verbunden ist.

## Claims

1. Apparatus for controlling an idle current for an amplifying transistor (T4), wherein the amplifying transistor (T4) comprises a control terminal (10c) and a first (10a) and a second (10b) terminal which are arranged so that the idle current can flow through the amplifying transistor (T4) via the first and the second terminal (10a, 10b), the apparatus comprising:
a mirror transistor (T3) having a control terminal (13c), a first terminal (13a) and a second terminal (13b), which is connectable to the amplifying transistor (T4), such that the mirror transistor (T3) forms a current mirror with the amplifying transistor (T4) so that the idle current of the amplifying transistor (T4) equals or is proportional to the current through the first and second terminal (13a, 13b) of the mirror transistor (13);
a detection means (T2, R1) for detecting the voltage at the first terminal (13a) of the mirror transistor (T3) and for supplying an output signal in response to the voltage at the first terminal (13a) of the mirror transistor (13), wherein the detection means comprises a detection transistor (T2) having a control terminal (15c) and a first and a second terminal (15a, 15b), wherein the control terminal (15c) can be electrically connected to a voltage source (18, 20), and wherein the first terminal (15a) is connected to the first terminal (13a) of the mirror transistor, and wherein the output signal of the detection means can be output at the second terminal (15b);
a feedback means (T1) for receiving the output signal of the detection means (T2, R1) and for supplying a feedback signal, which depends on the output signal of the detection means, to the control terminal (13c) of the mirror transistor (T3); and
a resistive means (R3) having two terminals, the first terminal of the resistive means (R3) being connectable to a voltage (18, 20) and the second terminal of the resistive means (R3) being connected to the first terminal (13a) of the mirror transistor, so that a current through the resistive means (R3), owing to the voltage (18, 20), is controllable by a signal at the control terminal (13c) of the mirror transistor.

2. Apparatus in accordance with claim 1,
wherein the feed back means comprises a feed back transistor (T1) having a control terminal (16c) and a first and a second terminal (16a, 16b), wherein the output signal of the detection means (T2, R1) is connected to the control terminal (16c), wherein the first terminal (16a) is connectable to a supply voltage (Vcc) for the apparatus, wherein the feed back signal can be output at the second terminal (16b), and
wherein the second terminal (16b) is connected to the control terminal (13c) of the mirror transistor (T3).

3. Apparatus in accordance with claim 2, wherein the feedback means comprises an emitter follower and/or a source follower.

4. Apparatus in accordance with one of the preceding claims,
wherein the detection means further comprises a resistive means (R1) which is connected between the voltage source (18, 20) and the second terminal (15b) of the detection transistor (T2).

5. Apparatus in accordance with one of the preceding claims,
wherein the voltage to which the first terminal of the resistive means (R3) is connectable is a constant reference voltage (18), wherein the detection means can be supplied by the constant reference voltage, and wherein the amplifying transistor (T4) and the feedback means (T1) can be supplied by a circuit supply voltage (Vcc).

6. Apparatus in accordance with one of the preceding claims,
wherein the voltage to which the first terminal of the resistive means (R3) is connectable is a circuit supply voltage (Vcc) with which the feedback means (T1) and the amplifying transistor (T4) can be supplied; and
wherein the detection means (T2) can be supplied with a voltage (22) whose variation with time corresponds to the variation with time of the supply voltage (Vcc) (20).

7. Apparatus in accordance with one of the preceding claims, also comprising:
a means (11) for impressing an additional current on the first terminal (13a) of the mirror transistor (T3).

8. Apparatus in accordance with one of the preceding claims,
wherein the control terminal (13c) of the mirror transistor (T3) is connectable to the control terminal (10c) of the amplifying transistor (T4) via an impedance network (R4, R5, C1),
wherein the second terminal (13b) of the mirror transistor is connectable to a circuit ground (14), and
wherein the second terminal (10b) of the amplifying transistor (T4) is connectable to the ground (14).

9. Apparatus in accordance with one of the preceding claims, which further comprises an attenuation means (C1; C1') for attenuating the tendency of said apparatus to oscillate.

10. Apparatus in accordance with claim 9, wherein the attenuation means is a capacitor (C1) which is connected between the base of the mirror transistor (T3) and a circuit ground (14).

11. Apparatus in accordance with claim 9, wherein the attenuation means is a capacitor (C1') which is connected between the input (16c) of the feedback means (T1) and a circuit ground (14).

12. Apparatus according to claim 10 or 11, wherein the capacitor comprises a capacitance value between 1 and 10 pF.

13. Amplifier circuit comprising:
an amplifying transistor (T4) having a control terminal (10c) and a first and a second terminal (10a, 10b), which are arranged so that an idle current can flow through the amplifying transistor (T4) via the first and the second terminal (10a, 10b);
an apparatus for controlling the idle current of the amplifying transistor (T4) in accordance with one of claims 1 to 12,
wherein the first terminal (10c) of the amplifying transistor is connectable to a supply voltage (Vcc);
wherein the second terminal (10b) of the amplifying transistor is connectable to a circuit ground (14);
wherein the control terminal (13c) of the mirror transistor (T3) is connected to the control terminal (10c) of the amplifying transistor (T4); and
wherein a useful signal (RF IN) can be applied to the control terminal (10c) of the amplifying transistor (T4), so that an amplified useful signal can be output at the first terminal (10a) of the amplifying transistor.

14. Amplifier circuit in accordance with claim 13, wherein the amplifying transistor (T4) and the mirror transistor (T3) are bipolar transistors.

15. Amplifier circuit in accordance with claim 14, wherein the amplifying transistor (T4) and the mirror transistor (T3) are heterobipolar transistors.

16. Amplifier circuit in accordance with one of claims 13 to 15, wherein the amplifying transistor (T4) and the mirror transistor (T3) are implemented as a monolithically integrated microwave circuit.

17. Amplifier circuit in accordance with one of claims 13 to 16, which is completely implemented as a monolithically integrated microwave circuit.

18. Amplifier circuit in accordance with one of claims 13 to 17, wherein the control terminal (13c) of the mirror transistor (T3) is connected to the control terminal (10c) of the amplifying transistor (T4) via an impedance network (R4, R5, C1).

## Revendications

1. Dispositif de réglage d'un courant de repos d'un transistor (T4) amplificateur, le transistor (T4) amplificateur ayant une borne (10c) de commande et une première borne (10a) et une deuxième borne (10b) qui sont disposées afin que le courant de repos puisse passer dans le transistor (T4) amplificateur en passant par la première et la deuxième bornes (10a, 10b), comprenant des caractéristiques suivantes :
un transistor (T3) miroir ayant une borne (13c) de commande, une première borne (13a) et une deuxième borne (13b) qui peut être reliée au transistor (T4) amplificateur de façon à ce que le transistor (T3) forme un miroir de courant avec le transistor (T4) amplificateur, de sorte que le courant de repos du transistor (T4) amplificateur soit égal ou proportionnel au courant passant par la première et la deuxième bornes (13a, 13b) du transistor (13) miroir ;
un dispositif (T2, R1) de détection de la tension sur la première borne (13a) du transistor (T3) miroir et d'envoi d'un signal de sortie sous forme de réaction à la tension sur la première borne (13a) du transistor (13) miroir, le dispositif de détection comprenant un transistor (T2) de détection ayant une borne (15c) de commande et une première et une deuxième bornes (15a, 15b), la borne (15c) de commande pouvant être reliée électriquement à une source (18, 20) de tension et la première borne (15a) étant reliée à la première borne (13a) du transistor miroir et le signal de sortie du dispositif de détection pouvant être émis sur la deuxième borne (15b) ;
un dispositif (T1) de réaction pour la réception du signal de sortie du dispositif (T2, R1) de détection et pour l'envoi d'un signal de réaction qui dépend du signal de sortie du dispositif de détection à la borne (13c) de commande du transistor (T3) miroir ; et
un dispositif (R3) résistant ayant deux bornes, une tension (18, 20) pouvant être appliquée à la première borne du dispositif (R3) résistant et la deuxième borne du dispositif (R3) résistant étant reliée à la première borne (13a) du transistor miroir, de sorte qu'un courant passant dans le dispositif (R3) résistant peut être réglé sur la base de la tension (18, 20) par un signal appliqué à la borne (13c) de commande du transistor (13) miroir.

2. Dispositif suivant la revendication 1,
dans lequel le dispositif de réaction a un transistor (T1) de réaction ayant une borne (16c) de commande et une première et une deuxième borne (16a, 16b), le signal de sortie du dispositif (T2, R1) de détection étant appliqué à la borne (16c) de commande, une tension (Vcc) d'alimentation du dispositif pouvant être appliquée à la première borne (16a), le signal de réaction pouvant être émis sur la deuxième borne (16b) et la deuxième borne (16b) étant reliée à la borne (13c) de commande du transistor (T3) miroir.

3. Dispositif suivant la revendication 2,
dans lequel le dispositif de réaction comporte un émetteur suiveur ou une source suiveuse.

4. Dispositif suivant l'une des revendications précédentes,
dans lequel le dispositif de détection comporte, en outre, un dispositif (R1) résistant qui est monté entre la source (18, 20) de tension et la deuxième borne (15b) du transistor (T2) de détection.

5. Dispositif suivant l'une des revendications précédentes,
dans lequel la tension qui peut être appliquée à la première borne du dispositif (R3) résistant est une tension (18) de référence constante, le dispositif de détection pouvant être alimenté en la tension de référence constante et le transistor (T4) amplificateur et le dispositif (T1) de réaction pouvant être alimentés par une tension (Vcc) d'alimentation du circuit.

6. Dispositif suivant l'une des revendications précédentes,
dans lequel la tension qui peut être appliquée à la première borne du dispositif (R3) résistant est une tension (Vcc) d'alimentation du circuit, par laquelle le dispositif (T1) de réaction et le transistor (T4) amplificateur peuvent être alimentés ; et
dans lequel le dispositif (T2) de détection peut être alimenté par une tension (22) dont la variation en fonction du temps correspond à la variation en fonction du temps de la tension (Vcc) (20) d'alimentation.

7. Dispositif suivant l'une des revendications précédentes, qui a en outre la caractéristique suivante :
un dispositif (11) d'injection d'un courant supplémentaire dans la première borne (13) du transistor (T3) miroir.

8. Dispositif suivant l'une des revendications précédentes,
dans lequel la borne (13c) de commande du transistor (T3) miroir peut être reliée à la borne (10c) de commande du transistor (T4) amplificateur par l'intermédiaire d'un réseau (R4, R5, C1) d'impédance,
dans lequel la deuxième borne (13b) du transistor miroir peut être mise à une masse (14) du circuit, et
dans lequel la deuxième borne (10b) du transistor (T4) amplificateur peut être mise à la masse (14).

9. Dispositif suivant l'une des revendications précédentes, qui comporte en outre un dispositif (C1, C1') d'amortissement d'une tendance à l'oscillation du dispositif.

10. Dispositif suivant la revendication 9,dans lequel le dispositif d'amortissement est un condensateur (C1) qui est monté entre la base du transistor (T3) miroir et une masse (14) du circuit.

11. Dispositif suivant la revendication 9, dans lequel le dispositif d'amortissement est un condensateur (C1') qui est monté entre l'entrée (16c) du dispositif (T1) de réaction et une masse (14) du circuit.

12. Dispositif suivant la revendication 10 ou 11, dans lequel le condensateur a une valeur de capacité comprise entre 1 et 10 pF.

13. Circuit amplificateur ayant les caractéristiques suivantes :
un transistor (T4) amplificateur ayant une bome (10c) de commande et une première et une deuxième bornes (10a, 10b) qui sont disposées de façon à ce qu'un courant de repos puisse passer dans le transistor (T4) amplificateur en passant par les première et les deuxième bornes (10a, 10b) ;
un dispositif de réglage du courant de repos du transistor (T4) amplificateur suivant l'une des revendications 1 à 12 ;
une tension (Vcc) d'alimentation pouvant être appliquée à la première borne (10c) du transistor amplificateur ;
la deuxième borne (10b) du transistor amplificateur pouvant être mise à une masse (14) de circuit ;
la borne (13c) de commande du transistor (T3) miroir étant reliée à la borne (10c) de commande du transistor (T4) amplificateur ; et
un signal (RF, IN) utile pouvant être appliqué à la borne (10c) de commande du transistor (T4) amplificateur de manière à pouvoir émettre sur la première borne (10a) du transistor amplificateur un signal utile amplifié.

14. Circuit amplificateur suivant la revendication 13, dans lequel le transistor (T4) amplificateur et le transistor (T3) miroir sont des transistors bipolaires.

15. Circuit amplificateur suivant la revendication 14, dans lequel le transistor (T4) amplificateur et le transistor (T3) miroir sont des transistors hétérobipolaires.

16. Circuit amplificateur suivant l'une des revendications 13 à 15, dans lequel le transistor (T4) amplificateur et le transistor (T3) miroir sont réalisés sous la forme d'un circuit micro-ondes intégré monolithiquement.

17. Circuit amplificateur suivant l'une des revendications 13 à 16, qui est réalisé entièrement sous la forme d'un circuit micro-onde intégré monolithiquement.

18. Circuit amplificateur suivant l'une des revendications 13 à 17, dans lequel la borne (13c) de commande du transistor (T3) miroir est reliée à la borne (10c) de commande du transistor (T4) amplificateur par l'intermédiaire d'un réseau (R4, R5, C1) d'impédance.
